(19) **Europäisches Patentamt / European Patent Office / Office européen des brevets**

(11) **EP 1 878 064 B1**

(12) **EUROPEAN PATENT SPECIFICATION**

(45) Date of publication and mention
of the grant of the patent:
**03.03.2010 Bulletin 2010/09**

(21) Application number: **06718285.7**

(22) Date of filing: **13.01.2006**

(51) Int Cl.:
**H01L 45/00** (2006.01)     **H01L 27/24** (2006.01)

(86) International application number:
**PCT/US2006/001194**

(87) International publication number:
**WO 2006/121473 (16.11.2006 Gazette 2006/46)**

(54) **METHOD AND STRUCTURE FOR PELTIER-CONTROLLED PHASE CHANGE MEMORY**

VERFAHREN UND STRUKTUR FÜR EINEN PELTIER-GESTEUERTEN
PHASENWECHSELSPEICHER

PROCEDE ET STRUCTURE POUR MEMOIRE A CHANGEMENT DE PHASE CONTROLEE DE
PELTIER

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **06.05.2005 US 123086**

(43) Date of publication of application:
**16.01.2008 Bulletin 2008/03**

(73) Proprietors:
- **International Business Machines Corporation
  Armonk, NY 10504 (US)**
- **Krusin-Elbaum, Lia
  Dobbs Ferry NY 10522 (US)**
- **Newns, Dennis M.
  Yorktown Heights NY 10598 (US)**

(72) Inventors:
- **KRUSIN-ELBAUM, Lia
  Dobbs Ferry, NY 10522 (US)**
- **NEWNS, Dennis, M.
  Yorktown Heights, NY 10598 (US)**

(74) Representative: **Williams, Julian David
  IBM United Kingdom Limited
  Intellectual Property Department
  Mail Point 110
  Hursley Park
  Winchester
  Hampshire SO21 2JN (GB)**

(56) References cited:
**WO-A-2004/021358     US-A- 4 598 395
US-A1- 2004 188 668**

**Description**

**BACKGROUND OF THE INVENTION**

*Field of the Invention*

The present invention generally relates to a memory or storage unit, and specifically to a non-volatile memory or storage unit. More specifically, Peltier elements provide both heating and cooling for a phase change material (PCM) element to greatly improve speed and controllability when only a thin layer of the PCM is used for storing the information state of the memory unit.

*Description of the Related Art*

The most widely used form of memory, dynamic random access memory (DRAM), has a number of well-known disadvantages. First, the memory is volatile, meaning that it is lost when the computer or device is switched off. Second, it is relatively slow. Third, it would be desirable to significantly reduce the memory "footprint" (e.g., the physical size of the memory unit).

These drawbacks have led to interest in a proposed new type of nonvolatile memory, phase change memory, or PRAM.

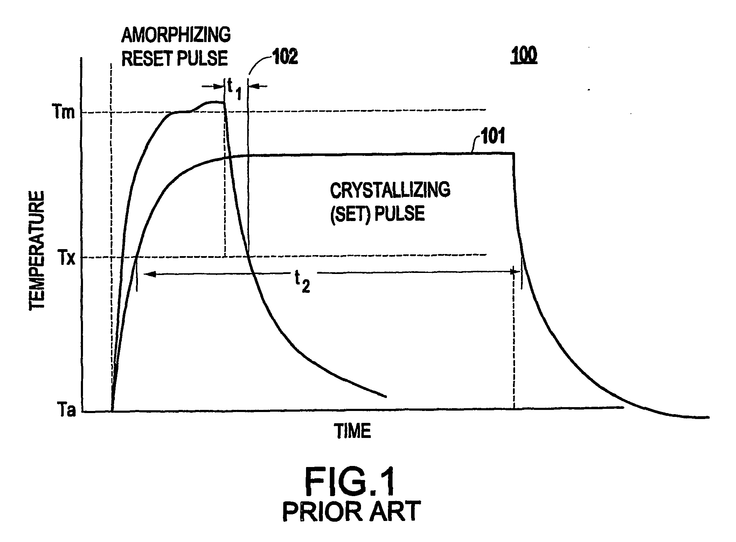

Phase change materials (PCM), which can coexist in either a crystalline or amorphous phase state, are currently the basis of commercial optical CD-RW disk technology, as well as the newly-proposed PRAM. In CD-RW, bit-spots on the disk may be in either of two phase states. Thermal cycling, done by extrinsic laser heating, interconverts the two states 100, as shown in Figure 1. Amorphous-to-crystalline conversion involves an anneal below melting point ("Set" process), while crystalline-to-amorphous conversion involves melting followed by a fast quench ("Reset" process). Spots are read by exploiting the different optical reflectivity of the two phases.

All current PRAM designs (termed here "conventional") have evolved from a concept based on ternary PCM compositions GeSbTe (germanium antimony tellurium), commonly abbreviated GST, having a highly resistive amorphous state and a low resistance crystalline state. A commonly-used GST is $Ge_2Sb_2Te_5$ (hereinafter, referred to as "GST 225").

To convert from the conductive to the resistive state, current is passed through the PCM, melting it via internal joule heating, followed by a quench to the resistive state. Converting from the resistive to the conductive state involves first driving the PCM to electrical breakdown, then passing current to anneal to the conductive state. The Read process exploits the different electrical resistivities of the two states, which are easily distinguished.

However, because the electrical breakdown process is non-linear and not easily controlled, there remains a need to improve PRAM designs. Moreover, current PRAM is too slow to compete effectively with DRAM.

Additionally, in view of the disadvantages identified above for DRAM, an improvement in PRAM design would ideally additionally address one or more of these disadvantages, thereby allowing PRAM to successfully compete with DRAM in at least some applications.

**SUMMARY OF THE INVENTION**

The present invention provides a memory cell as claimed in claim 1 and a method as claimed in claim 7.

In view of the foregoing, and other, exemplary problems, drawbacks, and disadvantages of the conventional system, it is an exemplary feature of the present invention to provide an improved PRAM memory cell.

It is another exemplary feature of the present invention to provide a technique in which information can be more rapidly placed (e.g., stored) into a PRAM memory cell by providing a cooling element for more rapid transition from a heating cycle used for placing (e.g., storing) information in the cell.

The present invention involves a memory cell, including a phase change material (PCM) element that stores an information bit and a Peltier device located in close proximity to a surface of the PCM element. The Peltier device serves to selectively heat/cool the surface of the PCM element. The information bit is stored in the PCM element within a PCM layer adjacent to the surface closest to the Peltier device, and the thickness of the PCM layer storing the information bit is in the nanoscopic range.

Thus, the present invention provides an improved PRAM memory cell wherein a cooling element increases a switching speed for establishing an information bit by reducing the amount of time for converting between amorphous and crystalline states, thereby providing improved performance, speed, and size over conventional PRAM devices and presents an advantageous new technology that is very promising as a storage class memory.

Moreover, a high performance PRAM, such as taught by the present invention, is suitable as a local nonvolatile memory embedded in the logic chip environment. In this application, following a run interruption, the *exact* logic state of the system can be restored, enabling seamless continuation of the interrupted task, an advantage not provided by DRAM.

A second application is in hand-held devices, such as portable computers (e.g., such as laptop computers), cell phones, portable audio and/or video devices, or the like, where the nonvolatile and high density properties of PRAM enable it to replace a compact disk, thereby enhancing additional miniaturization of these types of devices for which compactness is highly desired by consumers.

## BRIEF DESCRIPTION OF THE DRAWINGS

The foregoing and other exemplary features, aspects and advantages will be better understood from the following detailed description of an exemplary embodiment of the invention with reference to the drawings, in which:

Figure 1 illustrates the thermal cycling 100 for the set and reset processes of a phase change material, as might be used in conventional optical CD-RW disk technology;

Figure 2 exemplarily illustrates a cross section of a structure 200 of an exemplary embodiment of the present invention;

Figure 3 illustrates an exemplary memory cell configuration 300 using a Peltier heater/cooler and an FET switch;

Figure 4 illustrates cooling cycle curve 400 at 5 nm depth within the GST element; and

Figure 5 exemplarily illustrates a 3x3 memory array 500 using Peltier heater/cooler elements.

## DETAILED DESCRIPTION OF EXEMPLARY EMBODIMENTS OF THE INVENTION

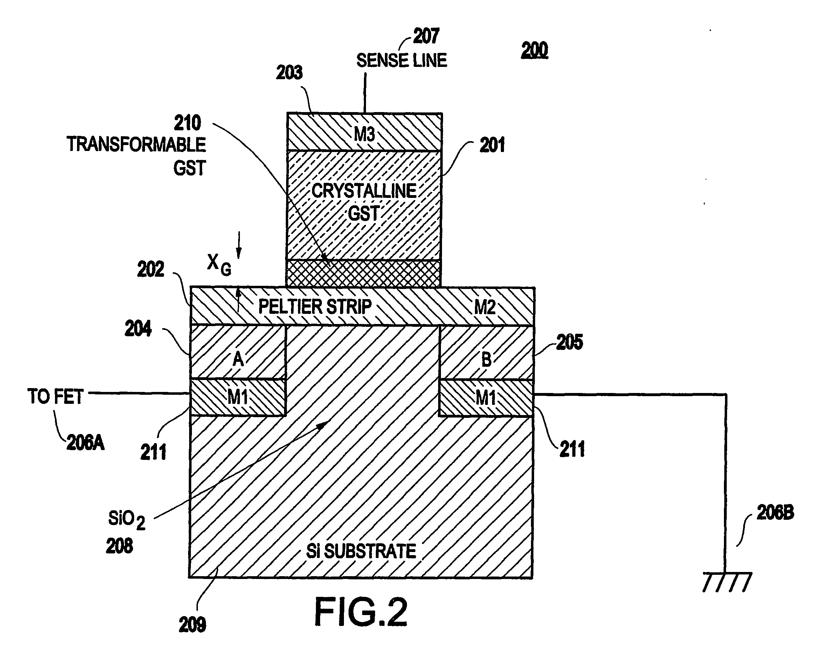

Referring now to the drawings, and more particularly to Figures 2-5, exemplary embodiments of the present invention will now be described.

PRAM based on new material compositions are currently being investigated, such as binary GeSb, having two orders of magnitude lower resistivity in both states (e.g., amorphous and crystalline). However, these new compositions are not suitable for the internal joule heating/electrical breakdown scenario, because the low resistance of the PCM in the crystalline state requires inconveniently high currents for convenient internal joule heating, while the amorphous state is too conductive for electrical breakdown.

Heating by an external element, whose properties are independent of the PCM state, offers a clean solution for these materials, bringing the PRAM closer in concept to the CD-RW. Moreover, there are advantages in terms of reproducibility and analyzability, including understanding of scaling, for applying the external heater solution also to the ternary PCM materials.

US Patent No. 7,129,560 demonstrated one configuration of an external heater in PRAM. The heater may be a thermocouple or the like.

US Patent no. 7,221,579 provides an extension to this basic concept of using an external heater for PRAM by describing how using only a thin PCM layer in close proximity to the external heater for the information storage of the memory cell allows the switching speed to be dramatically improved for PRAM devices.

The present invention adds the capability of cooling to a thin-layer PCM having an external heating element, apart from passive heat sinks like the substrate (US 7,129,560) or a metal grid surrounding the PCM structures as in WO 2004/21358A.

Additionally, the present inventors have recognized that greater controllability of the phase change process, with the promise of higher speed, could be assured if, in addition to heating, cooling could also be provided by an external element, so as to enhance the quench (Reset) process. Operability in a regime of faster crystallization would then be possible, speeding up also the anneal (Set) process.

This recognition suggested to the present inventors the possibility of extending the concept of an external heater to the concept of an external heater/cooler as embodied in a Peltier heater/cooler device.

The present invention, therefore, presents a novel PRAM memory cell wherein phase change is controlled by both the heating capability and the cooling capability of Peltier heater/cooler elements that are external to the PCM. Thus, the Peltier heater/cooler elements accomplish the Set and Reset processes by appropriate thermal cycling, utilizing both heating and cooling capabilities.

Because of its external heater element, in the present invention, current flows through the PCM element only during the read process, when the information content of the memory cell is determined by determining the resistivity of the PCM element. In the design of the present invention, in which a Peltier device serves as an external heater for the PCM element, current flows through the Peltier device in one sense to provide heat for the Set state of the PCM element and the initial stage of the Reset, but the current sense is reversed in the quench stage of Reset to provide cooling for the PCM element, hence speeding up the quench.

A second key aspect of the present invention is the use of small dimensions, which critically relate to speed of the device. That is, by incorporating film thicknesses, the present invention is highly controllable to small dimensions, including dimensions directly related to improving the speed of operation.

Thus, because of the external heater and the thin layers used, the exemplary design discussed herein provides a number of advantages, including:

- Reproducibility due to the absence of nonlinear electrical breakdown processes;
- Analyzability due to ohmic conduction and simple geometry;
- Applicability to a wide range of PCM compositions, since the thermal cycling is independent of PCM resistivity;
- High degree of control over the phase change process due to independent control of both heating and cooling processes;
- Heating power is linear in current, providing more power at low currents; and
- The key small dimensions of the device, which critically relate to speed, are thin film thicknesses, and, thus, easily fabricated precisely to low values.

Description and Function of a Single Cell

An exemplary memory cell configuration 200 of the present invention includes a GST element 201 sandwiched between two metal electrodes 202, 203, as shown in Figure 2. One electrode 202, termed the "Peltier strip", which connects two thermoelectric materials, A 204 (with a positive thermopower) and B 205 (with a negative thermopower), constitutes an external Peltier heater/cooler for the GST element 201.

The Peltier electrode A is connected to the FET switch drain 206A, while the B electrode is grounded 206B. The other electrode 203 attached to the GST element 201 is connected to a sense line 207.

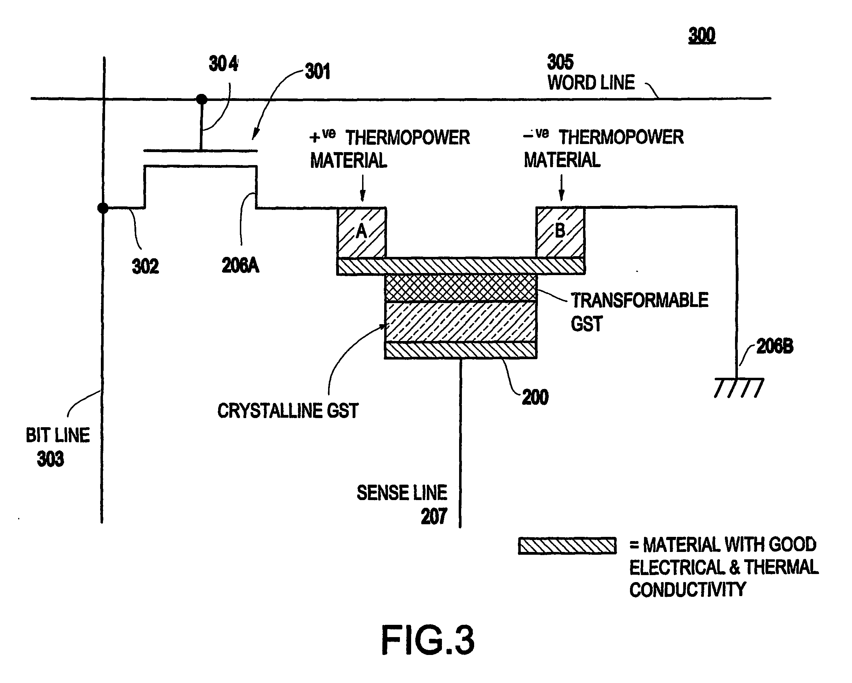

The device 200 is exemplarily shown in Figure 2 as constructed on top of an $SiO_2$ layer 208 on a silicon substrate 209. However, other insulators (oxides or nitrides) may be used as long a the thermal path discussed below is not compromised. Although not shown in Figure 2, the memory cell configuration 300 exemplarily illustrated in Figure 3 shows that the source 302 of FET 301 is connected to the bit line 303, while the gate 304 is connected to the word line 305. Functionality in PRAM involves three processes, including the two "write" processes Set and Reset, and a Sense (e.g., "read") process. All functions involve enabling a particular Word line 305 via the FET gate.

The Reset step melts a thin layer 210 of GST close to the Peltier electrode 202, named "transformable GST" in Figure 2. This melting is implemented by a current flowing from A to B (e.g., *from* the FET 206A and bit line 303), followed by a fast quench to a high-resistance amorphous state. The quenching is implemented by a reversed current, flowing from B to A (e.g., *into* the FET 206A and bit line 303), which achieves Peltier cooling of the transformable GST layer 210. During this process the Sense line is open circuited, thereby ensuring that no current flows through the GST material 201.

The Set step involves an anneal of the amorphous transformable GST layer 210 to a low-resistance crystalline state, which is achieved by Peltier heating (current flowing from A to B) to a lower temperature than required for melting, but for a longer time. Again, during this process the Sense line 207 is open circuited so that no current flows through the transformable GST layer 210.

The sense step involves determining the amorphous or crystalline state of the transformable GST layer 210 by interrogating its electric resistance with a sense amplifier, using the bit line 303 as a voltage source. During this process, the Sense line 207 is in the circuit.

Physical Implementation and Materials Aspects

Figure 2 shows an exemplary physical implementation of a memory section of a cell. A thermally and electrically insulating layer 208, such as $SiO_2$, is deposited on the silicon substrate 209, with a thickness of approximately 200-400 nm. This layer is patterned so as to obtain trenches into which the contact metal layer M1 (e.g., metal layer 1) 211 is deposited, followed by the deposition of the thermoelectric elements A and B 204, 205 (film thickness of approximately 100-200 nm) to form the Peltier heater/cooler assembly. After planarization of this layer, a metal layer M2, forming the Peltier strip 202, is patterned to contact elements A and B. The thickness of the M2 layer is approximately 10 nm, and one choice of material is TiN.

Preferably, the choice of the thermoelectric materials A and B is based on:

    1. The materials preferably should have a high Peltier coefficient (positive for A, negative for B);

2. The thermoelectric efficiency factor, defined as $ZT = \dfrac{\phantom{\Pi}}{\kappa T}$, where $\Pi$ is the Peltier coefficient, $\sigma$ is the electrical conductivity, and $\kappa$ is the thermal conductivity, of the A or B elements preferably should be of order unity or larger; and

3. The material preferably maintains this high thermoelectric efficiency up to the melting temperature of the GST.

Possible materials that satisfy these conditions include:

1. For material A, alkaline earth filled skutterudites, with the composition $AT_4Sb_{12}$, where A=Ca, Sr, Ba; and T = Fe, Ru. Additional choices are the skutterudites $IrSb_3$ , $HfTe_5$, $ZrTe_5$. A further choice is $AT_4X_{12}$, where composition materials involve A=La, Ce, Pr, Ne or Eu; T=Fe, Ru, or Os; and X=P, As, or Sb.

2. For material B, one choice is the half-Heusler alloys MNiSn, where M=Zn, Hf, Ti. These materials have huge negative thermopowers, good thermoelectric efficiency factor ZT, and operate at 700K. Moreover, their properties are tunable by doping. Another recent class of materials are cubic chalcogenides, with composition $AgPb_mSbTe_{2+m.}$ These latter materials may be particularly compatible with the processing of GST elements.

The next step is the deposition of LTO, which is subsequently patterned with vias down to M2 (e.g., metal layer # 2) level, that are filled with the GST (approx. thickness 15 nm). The final electrical contact 203 is an M3 metal layer made to the top of the GST element 201. M2 and/or M3 can be high $\kappa$ material, such as W or TaN.

## Technical Estimates of Cell Performance

The analysis of the exemplary configuration shown in Figures 2 and 3 assumes that the principal heat loss is through the oxide 208, due to its significantly larger specific heat-thermal conductivity product relative to that of GST 201. Hence, a one-dimensional analysis, in which heat propagation is normal to the plane of the Peltier heating/cooling element, can be used. Heat loss from the Peltier strip through the thermoelectric materials A and B, which characteristically have low thermal conductivities similar to $SiO_2$, will be similar to that through the oxide.

First, the materials parameters shown in Table I are considered. For definiteness, a GST material with the properties approximating those of the well-studied 225 material $Ge_2Sb_2Te_5$ is considered. The oxide parameters are those of $SiO_2$.

**Table I :** Specific Heat $C_p$, Thermal Conductivity $K$, electrical conductivity $\sigma$

| Phase | GST Cryst. | GST Amorph. | Oxide | Si |
|---|---|---|---|---|
| $C_p(J/(Kcm^3)$ | 1.3 | 1.3 | $3^{++}$ | 1.6 |
| $K(J/(Kcmsec))$* | 0.005 | 0.0017 | $0.013^{++}$ | $0.8^+$ |
| $\sigma$ (Ohm$^{-1}$cm$^{-1}$) | 100** | 0.001 | - | |
| * Dependent on source<br>** Controllable by N-doping.<br>$^+$ Average over<br>$^{++}$ *Typ.* | | | | |

The model is then a single-sided 1D model, in which temperature is considered as a function of $x$ and time $t$. Assuming excellent thermal conductivity of the Peltier strip, the temperature is considered to be uniform, with value $T_P$ (t), within the strip. The temperature distribution within the oxide is denoted as $\Phi_{ox}$ (x,t).

Within the oxide, the diffusion equation applies:

$$\frac{\partial \Phi_{ox}}{\partial t} = D_{ox} \frac{\partial^2 \Phi_{ox}}{\partial x^2}; \quad D_{ox} = \frac{K_{ox}}{C_{ox}},$$

where $K_{ox}, C_{ox}$ are the oxide thermal conductivity and volumetric specific heat, respectively. The diffusion equation is solved using Laplace transform techniques, and the results are stated in the asymptotic long-time limit which ignores the fast transients associated with thermal equilibration of the Peltier strip. The temperature $T_P$ in the Peltier strip can be written in terms of a function $f_P(t)$

$$f_P = \frac{2}{\sqrt{\pi K_{ox} C_{ox}}} t^{1/2},$$

in terms of which

$$T_P = \frac{W_H}{A} f_P(t) - \frac{(W_H + W_C)}{A} f_P(t - t_S)\theta(t - t_S).$$

Here, $W_H / A$ is the input heating power per unit area, $W_C / A$ is the input cooling power per unit area, and $A$ is the area. $t_S$ is the time at which the heating cycle is replaced by a cooling cycle during reset. $\theta(t)$ is the step function.

Given the temperature evolution in the Peltier strip, the temperature profile inside the GST can be determined as follows, using the function g(x,t)

$$g(x,t) = f_P(t)\left[e^{-z^2} - z\sqrt{\pi}\left(1 - erf(z)\right)\right],$$

where $z = x/\sqrt{4 D_G t}$, $D_G = K_G / C_G$ is the diffusion constant for GST, $K_G$ is the GST phase-averaged thermal conductivity, and $C_G$ is the GST specific heat. With this, the temperature profile $T_G(x,t)$ in the GST is given by

$$T_G(x,t) = \frac{W_H}{A} g(x,t) - \frac{(W_H + W_C)}{A} g(x, t - t_S)\theta(t - t_S).$$

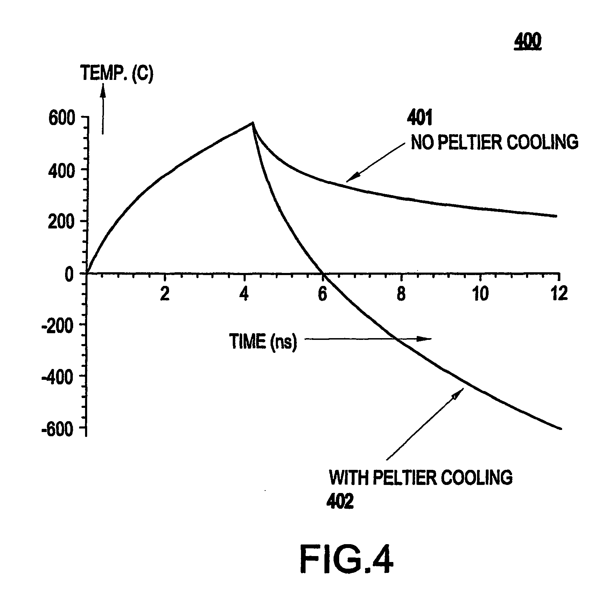

Figure 4 illustrates a graph 400 of the time evolution of temperature $T_G(x,t)$ within GST at a distance $x = x_G = $ 5 nm inside the surface, both without Peltier cooling 401 ($W_C = 0$), and with Peltier cooling 402 ($W_C = W_H$). The parameters are collected below

**Table II:** Parameters

| $x_G$(nm) | $I$(mA) | $S_A$ - $S_B$ ($\mu V/K$) | $A$ ($nm^2$) | $t_s$ (ns) |
|---|---|---|---|---|
| 5 | 0.167 | 300 | 50x50 | 4.2 |

From Fig. 4, it is seen that the Peltier cooling strongly enhances quench rate, as compared to just turning off the heating cycle.

The latent heat of crystallization, 420 Jcm$^{-3}$ for the 225 GST material, absorbs approximately ½ as much heat as required to raise the material from room temperature to the melting point, an effect which should be taken into account in the heat balance, but it introduces a nonlinear effect which is more difficult to treat analytically than the simple heat diffusion. Neglect of latent heat thus limits accuracy to an order of a factor of two.

The Set process time scale depends on the time for the crystallization front to travel from the interface between the amorphous and crystalline phases to the surface at the Peltier strip. With $x_G = $ 5 nm and crystallization front velocity $v_{cryst} = $ 2 m/sec, this would require 2.5 ns. However, the crystallization front velocity depends critically on temperature, so the lower the anneal temperature, the slower the Set process. The temperature dependence in the anneal process, and the latent heat should be taken into account.

The Sense process depends on the relatively large difference in resistivity between the amorphous and crystalline GST phases. When sense current is applied through the FET drain, the current $\times$ resistance of B acts as a voltage source driving current through the GST into the sense amplifier. With an electrical conductivity of $\sigma = $100 Ohm$^{-1}$cm$^{-1}$ (Table I), the 225 crystalline material in a thickness of 15 nm has a resistance of 600 $\Omega$, while with the thin (5 nm.) layer of amorphous GST in series, the resistance would be orders of magnitude higher. These numbers depend sensitively on the GST composition, dimensions, etc., and preferably are tailored accordingly.

## Memory Array

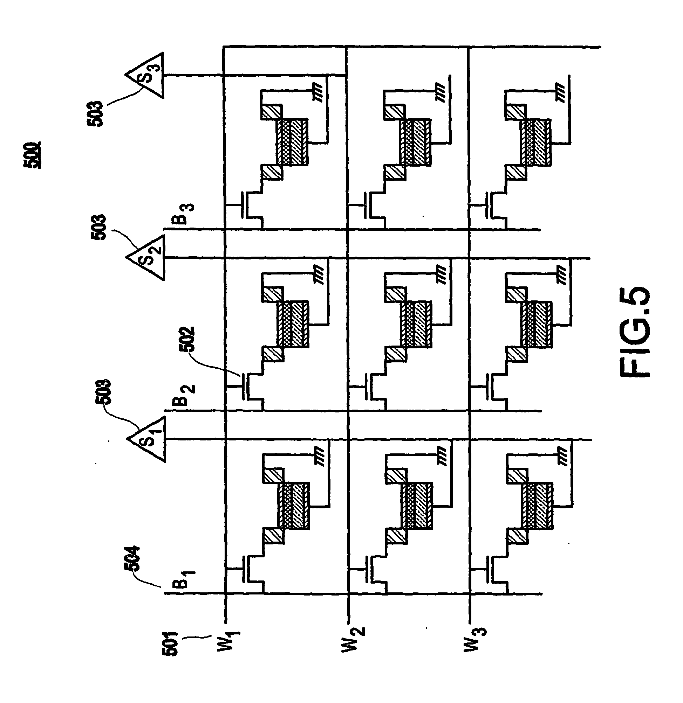

A 3x3 memory 500 is exemplarily illustrated in Fig. 5. Enabling a word line 501 is required for write and read processes. The FET switches 502 in that row are then turned on. For Set and Reset, the sense amplifiers 503 are open circuited, and current of appropriate directionality applied from the bitline 504.

For Sense, current is again applied from the bitline 504, now with the sense amplifiers 503 in the circuit. The sense amplifiers 503 detect a significant current only if the GST element is in the crystalline state. Typical block size of a memory, in practice, is 1024x1024 units of memory, rather than the 3x3 memory 500 shown in Figure 5.

## RC Time Constant, Memory Bandwidth

To calculate a time constant, the block physical dimension is estimated as $0.7 \times 10^{-2}$ cm. At an estimated 2 pF/cm lead capacitance per unit length, lead capacitance is on the order of $1.4 \times 10^{-14}$ F. Hence, for currents of 0.2 mA to charge to 1 V, the time constant is $0.7 \times 10^{-10}$ sec. This time constant is short enough so that the RC delay does not significantly affect circuit operation.

For Sense, the RC time constant leads to a delay of the order $0.8 \times 10^{-10}$ sec, which however is also insignificant.

The time delays from the ancillary circuitry (code/decode, etc.) are similar to that for DRAM, i.e., relatively long.

A 3-nsec write time yields a memory bandwidth, assuming a 1024-bit word line, in simultaneous read/write mode, interfacing with a 64-bit channel, of ~5GHz.

## Thermal Budget

For an applied voltage $V$, the heat for a single write step is estimated as, where $\tau$: is write time,

$$H_{wr} = VI\tau \approx 0.7 \times 10^{-12} J,$$

where it is taken that $V$=1V and $\tau$ =4 ns. Now a 3 GHz computer outputting 64 b/cycle to memory, i.e. $2 \times 10^{11}$ b/sec, will therefore require a maximum 130 mW of power for writing to memory. Even this maximal estimate is quite low. The power requirement for a read is similar.

The power requirement of the ancillary circuitry (code/decode, etc.) is similar to that for DRAM.

The high performance PRAM of the present invention is suitable as a local nonvolatile memory embedded in the logic chip environment. In this application, following a run interruption the exact logic state of the system can be restored, thereby enabling seamless continuation of the interrupted task. A second application is in hand-held devices, where the nonvolatile and high density properties of PRAM enable it to replace the compact disk (CD), enhancing miniaturization.

## Claims

1. A memory cell (200), comprising:

   a phase change material (PCM) element (201) for storing an information bit; and
   a heating and cooling means external to said PCM element for changing said information bit by heating said PCM element by flowing a current through a Peltier strip (202) in one direction and subsequently by cooling said PCM element by flowing a current through said Peltier strip in an opposite direction to said one direction.

2. The memory cell of claim 1, wherein said PCM comprises a chalcogenide glass.

3. The memory cell of claim 1, wherein said PCM comprises one of:

   a ternary germanium antimony tellurium (GeSbTe or GST) composition; and
   a binary germanium antimony (GeSb) composition.

**4.** The memory cell of claim 1, wherein said heating and cooling means comprises:

an electrode (204) having a positive thermopower characteristic; and
an electrode (205) having a negative termopower characteristic.

**5.** The memory cell of claim 1, further comprising:

a switching element to control application of a voltage to said memory cell.

**6.** An apparatus, comprising:

a memory array (500), comprising:

a plurality of memory cells arranged in an array of rows and columns;
a word line (501) for at least one said row, said word line connected to at least one memory cell in said row;
a bit line (504) for at least one said column, said bit line connected to at least one memory cell in said column; and
a sense amplifier (503) in each said bit line,

wherein at least one of said memory cells comprises the memory cell of any preceding claim.

**7.** A method comprising steps of:

heating a PCM element (201) of a phase change material (PCM) random access memory (PRAM), by flowing a current through a Peltier strip (202) in one direction; and
cooling said PCM element by flowing a current through said Peltier strip in an opposite direction to said one direction.

**8.** The method of claim 7 wherein said phase change material stores bit information within a PCM layer having a thickness in the nanoscopic range.

**9.** The method of claim 7 wherein said Peltier strip comprises TiN.

**10.** The method of claim 7 wherein a switching element controls application of a voltage to flow the current.


**Patentansprüche**

**1.** Speicherzelle (200), welche das Folgende umfasst:

ein Phasenwechselmaterial(PCM)-Element (201) zum Speichern eines Informations-Bits; und
ein Heiz- und Kühlmittel außerhalb des PCM-Elements zum Verändern des Informations-Bits durch Erwärmen des PCM-Elements durch Leiten eines Stroms durch einen Peltier-Streifen (202) in eine Richtung und anschließend durch Kühlen des PCM-Elements durch Leiten eines Stroms durch den Peltier-Streifen in eine Gegenrichtung.

**2.** Speicherzelle nach Anspruch 1, wobei das PCM ein Chalcogenidglas umfasst.

**3.** Speicherzelle nach Anspruch 1, wobei das PCM eine der folgenden Zusammensetzungen umfasst:

eine dreigliedrige Germanium-Antimon-Tellur-Zusammensetzung (GeSbTe oder GST); oder
eine zweigliedrige Germanium-Antimon-Zusammensetzung (GeSb).

**4.** Speicherzelle nach Anspruch 1, wobei das Heiz- und Kühlmittel das Folgende umfasst:

eine Elektrode (204), welche eine positive thermoelektrische Charakteristik aufweist; und
eine Elektrode (205), welche eine negative thermoelektrische Charakteristik aufweist.

**5.** Speicherzelle nach Anspruch 1, welche ferner das Folgende umfasst:

ein Schaltelement, um das Anlegen einer Spannung an die Speicherzelle zu steuern.

**6.** Vorrichtung, welche das Folgende umfasst:

ein Speicherfeld (500), welche das Folgende umfasst:

mehrere Speicherzellen, welche in einem Feld von Reihen und Spalten angeordnet sind;
eine Wortleitung (501) für mindestens eine der Reihen, wobei die Wortleitung mit mindestens einer Speicherzelle in der Reihe verbunden ist;
eine Bitleitung (504) für mindestens eine der Spalten, wobei die Bitleitung mit mindestens einer Speicherzelle in der Spalte verbunden ist; und
einen Leseverstärker (503) in jeder Bitleitung,

wobei mindestens eine der Speicherzellen die Speicherzelle nach einem der vorhergehenden Ansprüche umfasst.

**7.** Verfahren, welches die folgenden Schritte umfasst:

Erwärmen eines PCM-Elements (201) eines Phasenwechselmaterial(PCM)-Direktzugriffsspeichers (PRAM) durch Leiten eines Stroms durch einen Peltier-Streifen (202) in eine Richtung; und
Kühlen des PCM-Elements durch Leiten eines Stroms durch den Peltier-Streifen in eine Gegenrichtung.

**8.** Verfahren nach Anspruch 7, wobei das Phasenwechselmaterial Bit-Informationen in einer PCM-Schicht speichert, welche eine Dicke im Nanobereich aufweist.

**9.** Verfahren nach Anspruch 7, wobei der Peltier-Streifen TiN umfasst.

**10.** Verfahren nach Anspruch 7, wobei das Anlegen einer Spannung, um den Strom fließen zu lassen, über ein Schaltelement gesteuert wird.


**Revendications**

**1.** Cellule de mémoire (200) comprenant :

un élément en matériau à changement de phase (PCM) (201) destiné à mémoriser un bit d'information, et
un moyen de chauffage et de refroidissement externe audit élément en matériau PCM destiné à changer ledit bit d'information en chauffant ledit élément en matériau PCM en faisant circuler un courant à travers une barrette à effet Peltier (202) dans un premier sens et ensuite en refroidissant ledit élément en matériau PCM en faisant circuler un courant à travers ladite barrette à effet Peltier dans un sens opposé audit premier sens.

**2.** Cellule de mémoire selon la revendication 1, dans lequel ledit matériau PCM comprend un verre de chalcogénure.

**3.** Cellule de mémoire selon la revendication 1, dans laquelle le dit matériau PCM comprend l'une de :

une composition ternaire de germanium, d'antimoine et de tellure (GeSbTe ou GST), et
une composition binaire de germanium et d'antimoine (GeSb).

**4.** Cellule de mémoire selon la revendication 1, dans laquelle le dit moyen de chauffage et de refroidissement comprend :

une électrode (204) ayant une caractéristique de puissance thermique positive, et
une électrode (205) ayant une caractéristique de puissance thermique négative.

**5.** Cellule de mémoire selon la revendication 1, comprenant en outre
un élément de commutation destiné à commander l'application d'une tension à ladite cellule de mémoire.

**6.** Dispositif comprenant :

une matrice mémoire (500) comprenant :

une pluralité de cellules de mémoire agencées en une matrice constituée de rangées et de colonnes, une ligne de mots (501) pour au moins une dite rangée, ladite ligne de mots étant connectée à au moins une cellule de mémoire dans ladite rangée, une ligne de bits (504) pour au moins une dite colonne, ladite ligne de bits étant connectée à au moins une cellule de mémoire dans ladite colonne, et un amplificateur de détection (530) dans chaque dite ligne de bits,

où au moins l'une desdites cellules de mémoire comprend la cellule de mémoire selon l'une quelconque des revendications précédentes.

7. Procédé comprenant les étapes consistant à :

chauffer un élément en matériau PCM (201) d'une mémoire vive en matériau à changement de phase (PRAM) en faisant circuler un courant à travers une barrette à effet Peltier (202) dans un premier sens, et refroidir ledit élément PCM en faisant circuler un courant à travers la dite barrette à effet Peltier dans un sens opposé audit premier sens.

8. Procédé selon la revendication 7, dans lequel ledit matériau à changement de phase mémorise des informations de bits dans une couche de matériau PCM ayant une épaisseur dans la plage nanoscopique.

9. Procédé selon la revendication 7, dans lequel ladite barrette à effet Peltier comprend du TiN.

10. Procédé selon la revendication 7, dans lequel un élément de commutation commande l'application d'une tension pour faire circuler le courant.

**FIG.1**
PRIOR ART

EP 1 878 064 B1

FIG.2

EP 1 878 064 B1

+ve THERMOPOWER MATERIAL

−ve THERMOPOWER MATERIAL

A

B

300

304

301

305
WORD LINE

302

206A

TRANSFORMABLE
GST

CRYSTALLINE GST

200

206B

BIT LINE
303

SENSE LINE
207

= MATERIAL WITH GOOD
ELECTRICAL & THERMAL
CONDUCTIVITY

FIG.3

EP 1 878 064 B1

TEMP. (C)

**400**

600

400

200

0

-200

-400

-600

2    4    6    8    10    12

**401**
NO PELTIER COOLING

TIME (ns)

WITH PELTIER COOLING
**402**

# FIG.4

EP 1 878 064 B1

FIG.5

EP 1 878 064 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7129560 B
- US 7221579 B
- WO 200421358 A